(19) Europäisches Patentamt
European Patent Office
Office européen des brevets

(11) **EP 4 254 064 A1**

(12) **EUROPEAN PATENT APPLICATION**

(43) Date of publication:
**04.10.2023 Bulletin 2023/40**

(21) Application number: **23165881.6**

(22) Date of filing: **31.03.2023**

(51) International Patent Classification (IPC):
**G03F 1/36** (2012.01)  **G03F 7/00** (2006.01)
**G06F 30/398** (2020.01)

(52) Cooperative Patent Classification (CPC):
**G03F 1/36; G03F 7/70441; G06F 30/398**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **01.04.2022 KR 20220041164**

(71) Applicant: Samsung Electronics Co., Ltd.
Suwon-si, Gyeonggi-do 16677 (KR)

(72) Inventors:
• LEE, Jee Yong
16677 Suwon-si (KR)
• LEE, Soo Yong
16677 Suwon-si (KR)
• HEO, Yang Woo
16677 Suwon-si (KR)

(74) Representative: **Marks & Clerk LLP**
**15 Fetter Lane**
**London EC4A 1BW (GB)**

(54) **PROCESS PROXIMITY CORRECTION METHOD AND COMPUTING DEVICE FOR THE SAME**

(57) A process proximity correction method includes receiving a first layout (L1) including first to m-th regions (R), wherein each of the first to m-th regions (R) include first to m-th patterns; and generating a second layout by performing machine learning-based process proximity correction based on first to n-th features of the first to m-th patterns. Here, m is a natural number equal to or greater than 3 and n is a natural number greater than or equal to 2.

## FIG. 6

L1

R1
$(C_1^1 F_1^1 + \cdots + C_k^1 F_k^1)$ R5   R7   R8

R4

R2
$(C_1^2 F_1^2 + \cdots + C_k^2 F_k^2)$

R1 ~ R8
$(C_{k+1} F_{k+1} + \cdots + C_n F_n)$

0
$(F_1^1, \cdots, F_k^1, F_1^2, \cdots, F_k^2, F_1^3, \cdots, F_k^3, \cdots, F_{k+1}, \cdots, F_n)$

R3
$(C_1^3 F_1^3 + \cdots + C_k^3 F_k^3)$   R6

EP 4 254 064 A1

**Description**

**Technical Field**

The present disclosure relates to a process proximity correction method and a computing device for performing the method.

**Discussion of Related Art**

A semiconductor process that manufactures a semiconductor device may be performed using various procedures such as etching, deposition, planarization, growth, and implantation. The etching may be performed by forming a photoresist pattern on a target, and removing portions of the target that are not protected by the photoresist using chemicals, gas, plasma, an ion beam, or the like.

In a process of performing the etching, a process error may occur due to various factors. The factors causing the process error may be due to characteristics of the process, but may also be due to characteristics of the photoresist pattern or a semiconductor pattern formed by the etching. The process error due to the characteristics of the pattern may be compensated for by correcting or changing a layout of the patterns.

As an integration level of the semiconductor device increases and a size of the semiconductor process is reduced, the number of patterns included in a semiconductor layout rapidly increases. However, changing the layout of a large number of patterns to compensate for the process error increases manufacturing time and cost.

**SUMMARY**

At least one embodiment of the present disclosure provides a process proximity correction method in which process proximity correction on multiple regions is performed using a process proximity correction model. In this method, process proximity correction may be performed on a pattern overlapping a region boundary with increased consistency.

At least one embodiment of the present disclosure provides a process proximity correction computing device in which process proximity correction is performed on multiple regions using a process proximity correction model. In this computing device, process proximity correction may be performed on a pattern overlapping a region boundary with increased consistency.

According to an embodiment, a process proximity correction method includes receiving a first layout including first to m-th regions, wherein each of the first to m-th regions include first to m-th patterns; and generating a second layout by performing machine learning-based process proximity correction based on first to n-th features of the first to m-th patterns. Here m is a natural number equal to or greater than 3 and n is a natural number greater than or equal to 2. In an embodiment, each of the first to k-th features includes first to l-th sub-features of each of the first to l-th patterns included in each of the first to l-th regions, k is a natural number smaller than or equal to n and l is a natural number smaller than or equal to m.

According to an embodiment, a process proximity correction method includes receiving a first layout including a first region including a first pattern, a second region including a second pattern, and a third region including a third pattern; extracting first to third features of the first to third patterns; and generating a process proximity correction model, wherein the generating of the process proximity correction model includes performing machine learning on: first-first feature data about the first feature of the first pattern included in the first region; first-second feature data about the first feature of the second pattern included in the second region; second feature data about the second feature of the first to third patterns respectively included in the first to third regions; and measure data of an after-cleaning inspection (ACI) image generated from the first layout; correcting the first layout to generate a second layout; predicting an ACI image of the second layout using the process proximity correction model; and correcting the second layout based on a difference between the predicted ACI image and a target ACI image.

According to an embodiment, a computing device for performing process proximity correction, the device includes a plurality of processors, wherein at least one of the processors performs the process proximity correction. The at least one processor for performing the process proximity correction is configured to: receive a first layout including first to m-th regions, wherein each of the first to m-th regions include first to m-th patterns and m is a natural number equal to or greater than 3; and generate a second layout by performing machine learning-based process proximity correction based on first to n-th features of the first to m-th patterns, where n is a natural number greater than or equal to 2. In an embodiment, each of the first to k-th features includes first to l-th sub-features of each of the first to l-th patterns included in each of the first to l-th regions, where k is a natural number smaller than or equal to n and l is a natural number smaller than or equal to m.

At least some of the above and other features of the invention are set out in the claims.

## BRIEF DESCRIPTION OF DRAWINGS

The above and other aspects and features of the present disclosure will become more apparent by describing in detail example embodiments thereof with reference to the attached drawings, in which:

FIG. 1 is an illustrative block diagram illustrating a computing device according to an embodiment;
FIG. 2 is an illustrative flowchart illustrating a process proximity correction method according to an embodiment;
FIG. 3 to FIG. 9 are illustrative views showing a process proximity correction method according to an embodiment;
FIG. 10 is an illustrative flowchart illustrating a method for generating a process proximity correction model according to an embodiment;
FIG. 11 is an illustrative view showing a method for generating a process proximity correction model according to an embodiment;
FIG. 12 and FIG. 13 are illustrative views showing a process proximity correction method according to an embodiment;
FIG. 14 is an illustrative flowchart illustrating a process proximity correction method according to an embodiment; and
FIG. 15 is an illustrative flowchart illustrating a method for manufacturing a semiconductor device according to an embodiment.

## DETAILED DESCRIPTION

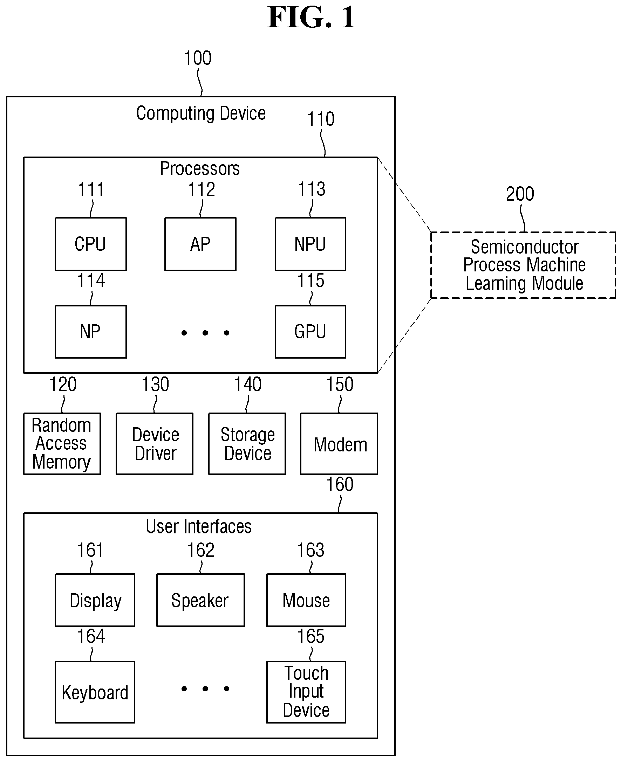

FIG. 1 is an illustrative block diagram illustrating a computing device according to an embodiment.

Referring to FIG. 1, a computing device 100 according to an embodiment includes a plurality of processors 110, a random-access memory 120, a device driver 130, a storage device 140, a modem 150 and a plurality of user interfaces 160.

At least one of the plurality of processors 110 may execute a semiconductor process machine learning module 200. The semiconductor process machine learning module 200 may generate a layout for manufacturing a semiconductor device based on machine learning. In an embodiment, the layout is an electronic representation of an integrated circuit indicating information on sizes, dimensions, and positions of geometric shapes that correspond to patterns of metal, oxide, or semiconductor layers that make up components of the integrated circuit.

For example, the semiconductor process machine learning module 200 may be implemented in a form of instructions (or codes) executed by at least one of the plurality of processors 110. In this case, the at least one processor may load the instructions (or codes) of the semiconductor process machine learning module 200 into the random-access memory 120.

In another example, at least one processor may be configured to implement the semiconductor process machine learning module 200. In still another example, at least one processor may be configured to implement various machine learning modules. At least one processor may receive information corresponding to the semiconductor process machine learning module 200 and may implement the semiconductor process machine learning module 200 based on the information. For example, the semiconductor process machine learning module 200 may be a computer program executed by the at least one processor.

The plurality of processors 110 may include, for example, at least one general-purpose processor such as a central processing unit (CPU) 111, an application processor (AP) 112, and the like. The plurality of processors 110 may further include at least one special-purpose processor such as a neural processing unit 113, a neuromorphic processor 114, a graphics processing unit (GPU) 115, and the like. The plurality of processors 110 may include two or more processors of the same type. While FIG. 1 depicts a CPU 111, an AP 112, a neural processing unit 113, a neuromorphic processor 114, and a graphics processing unit (GPU) 115, one or more of these may be omitted in an alternate embodiment.

The random-access memory 120 may be used as an operating memory for the plurality of processors 110, and may be used as a main memory or a system memory for the computing device 100. The random-access memory 120 may include a volatile memory such as a dynamic random access memory or a static random access memory, or a nonvolatile memory such as a phase change random access memory, a ferroelectric random access memory, a magnetic random access memory, or a resistive random access memory.

The device driver 130 may control peripheral devices such as the storage device 140, the modem 150, and the plurality of user interfaces 160 based on a request of the plurality of processors 110. The storage device 140 may include a fixed storage device such as a hard disk drive, a solid-state drive, or the like, or a removable storage device such as an external hard disk drive, an external solid state drive, a removable memory card, etc.

The modem 150 may provide remote communication with an external device. The modem 150 may perform wireless or wired communication with the external device. The modem 150 may communicate with the external device via at least one of various communication protocols such as Ethernet, Wi-Fi, LTE, and 5G mobile communication.

The plurality of user interfaces 160 may receive information from, and provide information to, a user. The plurality of user interfaces 160 may include at least one user output interface such as a display 161 and a speaker 162, and at least one user input interface such as a mouse 163, a keyboard 164, and a touch input device 165.

The commands (or codes) of the semiconductor process machine learning module 200 may be received through the modem 150 and stored in the storage device 140. The instructions (or codes) of the semiconductor process machine learning module 200 may be stored in a removable storage device which in turn may be coupled to the computing device 100. The commands (or codes) of the semiconductor process machine learning module 200 may be loaded from the storage device 140 into the random-access memory 120 and then may be executed.

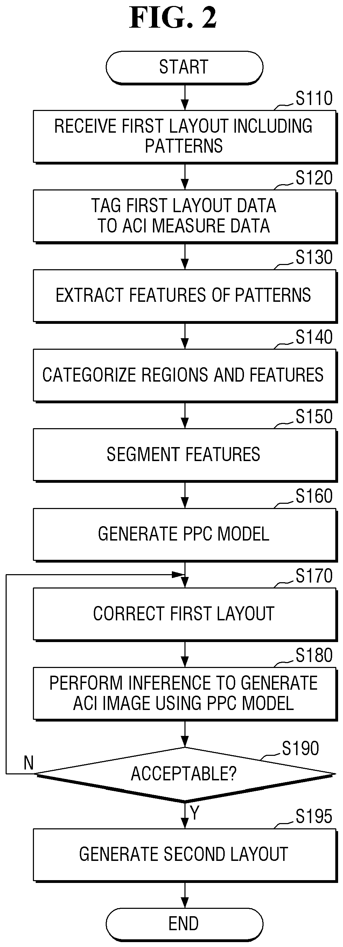

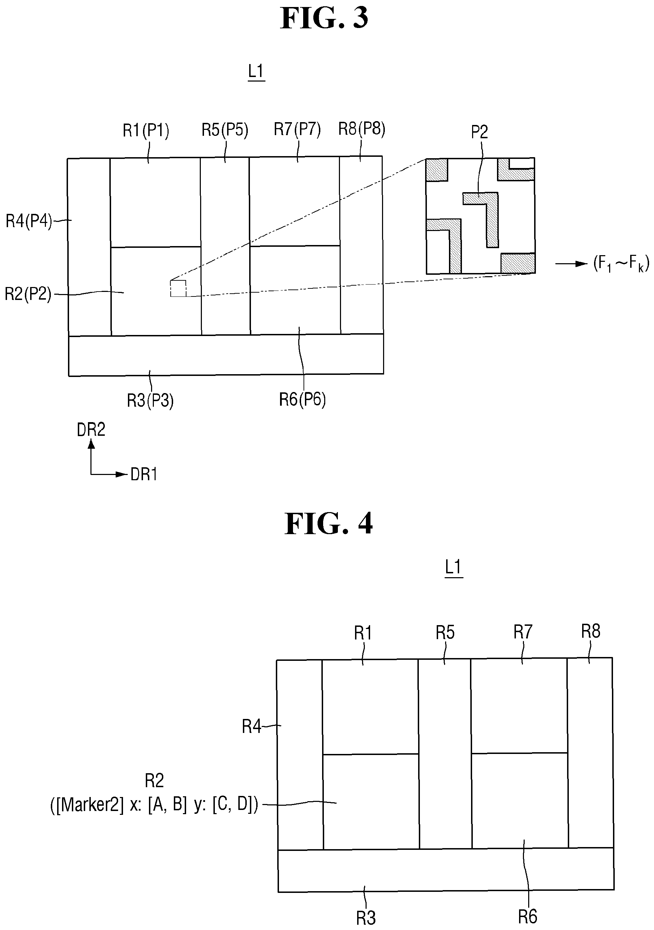

FIG. 2 is an illustrative flowchart illustrating a process proximity correction method according to an embodiment. FIG. 3 to FIG. 9 are illustrative views showing a process proximity correction method according to some embodiments.

Referring to FIG. 1 and FIG. 2, the computing device 100 according to an embodiment may perform process proximity correction (PPC) using the semiconductor process machine learning module 200 that is executed via at least one of the plurality of processors 110. The semiconductor process machine learning module 200 according to an embodiment performs the process proximity correction on a layout for manufacturing a semiconductor device, based on machine learning.

The semiconductor process machine learning module 200 receives a first layout including a plurality of patterns in S110. The first layout may be a target layout desired to be obtained in an after-cleaning inspection (ACI). For example, the ACI may be an inspection of a manufactured circuit that determines whether the circuit is damaged after it has been cleaned.

Referring to FIG. 3, in an embodiment, the first layout L1 includes a plurality of regions R1 to R8. An example in which the first layout L1 includes the first to eighth regions R1 to R8 will be described. The first to eighth regions R1 to R8 may respectively include first to eighth patterns P1 to P8. That is, the first region R1 may include the first pattern P1 and the second region R2 may include the second pattern P2. Each of the first to eighth patterns P1 to P8 may include a plurality of sub-patterns. Each of the first to eighth patterns P1 to P8 may include a plurality of sub-patterns having various sizes or various shapes. That is, the first pattern P1 is patterns in the first region P1, and the second pattern P2 is patterns in the second region R2.

In an embodiment, each of the plurality of regions R1 to R8 of the first layout L1 may be identified based on a function performed by elements disposed in each of the plurality of regions R1 to R8. For example, the first layout L1 may be a layout for manufacturing a memory device, and each of the first to eighth regions R1 to R8 may be one of a memory cell region, a row decoder region, and a peripheral region. For example, the memory cell region may include memory cells, the row decoder region may include a row decoder or logic circuit for activating word-lines connected to the memory cells in response to an address, and the peripheral region may be a region outside the other regions that includes wires, pads, etc. For example, each of the first region R1, the second region R2, the sixth region R6, and the seventh region R7 may be the memory cell region, while each of the fourth region R4, the fifth region R5, and the eighth region R8 may be the row decoder region, while the third region R3 may be the peripheral region.

In an embodiment, each of the plurality of regions R1 to R8 of the first layout L1 is identified based on a corresponding marker. The first layout L1 may include a marker indicating each of the regions R1 to R8. For example, referring to FIG. 4, the second region R2 may be identified based on a marker Marker2 indicating coordinates (x: [A, B] y:[C, D]) of the second region R2 in the first layout L1. FIG. 4 shows only the marker Marker2 of the second region R2. However, the first layout L1 may further include a marker for each of the first region R1 and the third to the eighth regions R3 to R8. For example, 'A' may mean a minimum value of the x-coordinate of the second region R2, 'B' may mean a maximum value of the x-coordinate of the second region R2, 'C' may mean a minimum value of the y-coordinate of the second region R2, and 'D' may mean a maximum value of the y-coordinate of the second region R2.

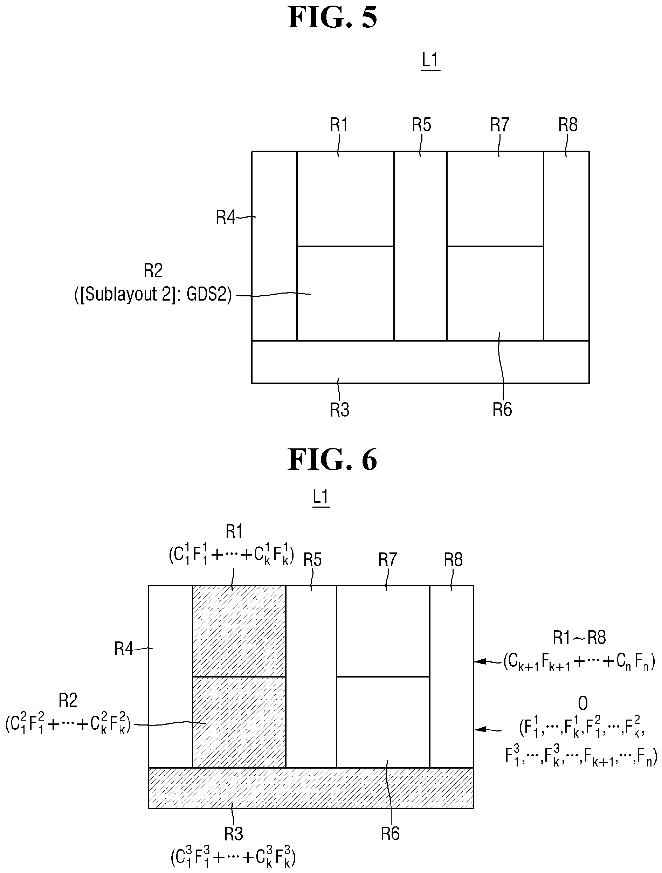

In an embodiment, each of the plurality of regions R1 to R8 of the first layout L1 is identified based on a corresponding sub-layout. The first layout L1 may include a sub-layout for each of the regions R1 to R8. For example, referring to FIG. 5, the second region R2 may be identified based on a sub-layout [Sublayout 2] of the second region R2. The second region R2 may be embodied as a GDS file GDS2. FIG. 5 shows only the sub-layout [Sublayout 2] of the second region R2. However, the first layout L1 may further include sub-layouts for the first region R1 and the third to eighth regions R3 to R8, respectively.

Referring back to FIG. 1 and FIG. 2, the semiconductor process machine learning module 200 tags or labels first layout data with ACI measure data in S120. The first layout data may include information about a plurality of patterns included in the first layout. The ACI measure data may be measure data of an ACI image actually generated from a semiconductor process using the first layout. For example, coordinates of a first pattern included in the first layout may be tagged or labelled with ACI measure data corresponding to the first pattern. For example, the ACI measure data may include a line width (CD) of a line of the ACI image. In an embodiment, the ACI image is an image of a manufactured circuit after it has been cleaned and inspected for defects and determined not to have any defects.

The semiconductor process machine learning module 200 extracts a plurality of features of a plurality of patterns included in the first layout in S130. The plurality of features may include features of each pattern or an influence which each pattern receives during etching due to neighboring patterns thereto. For example, the influence may be an influence of characteristics of patterns or an influence of an etch skew, when performing etching. For example, the influence may be the influence that a pattern experiences in etching from neighboring patterns placed around each pattern. The plurality of features may include, for example, sizes of the plurality of patterns, shapes of the plurality of patterns, a density of the plurality of patterns, a distance between two neighboring patterns, a size of one pattern and a size of a neighboring pattern thereto, an angle between one pattern and a neighboring pattern thereto, a position in a vertical direction of each of the plurality of patterns, and the like. For example, when the semiconductor device includes a first layer and a second layer stacked vertically on the first layer, a position in the vertical direction of each of the plurality of patterns may indicate whether the corresponding pattern is located on the first layer or the second layer. The first layer may correspond to a first layout and the second layer may correspond to a second other layout.

The semiconductor process machine learning module 200 may categorize the plurality of regions of the first layout into individual regions and a shared region, and categorize the plurality of features of the plurality of patterns into individual features and shared features in S140. For example, the semiconductor process machine learning module 200 may categorize the plurality of regions of the first layout into the individual regions and the shared region and categorize the plurality of features of the plurality of patterns into the individual features and shared features, based on a value input via one of the plurality of user interfaces 160.

The semiconductor process machine learning module 200 may segment the individual features into sub-features corresponding to individual regions in S150.

The semiconductor process machine learning module 200 may perform machine learning based on the segmented sub-features of each of the individual features and the shared feature and thus may generate a process proximity correction model in S160.

Referring to FIG. 6, the semiconductor process machine learning module 200 may categorize the plurality of regions R1 to R8 of the first layout L1 into the individual regions and the shared regions, wherein a tendency of the ACI image may be individually predicted in each of the individual regions, and the tendency of the ACI image may be predicted in a combination of the shared regions. In one example, the semiconductor process machine learning module 200 may categorize the first to third regions R1, R2, and R3 as the individual regions in which the tendency of the ACI image may be individually predicted in each of the individual regions, and may categorize the fourth to eighth regions R4, R5, R6, R7, and R8 as the shared regions in which the tendency of the ACI image may be predicted in a combination of the shared regions.

The semiconductor process machine learning module 200 may categorize a plurality of features $F_1$ to $F_n$ (n is a natural number equal to or larger than 2) into individual features and shared features. A tendency of the ACI image may be individually predicted from each of the individual features, and the tendency of the ACI image may be predicted using a combination of the shared features. In one example, the semiconductor process machine learning module 200 categorizes the first to k-th features $F_1$ to $F_k$ (k is a natural number equal to or less than n) as the individual features and may categorize the (k+1)-th to n-th features $F_{k+1}$ to $F_n$ as the shared features. A tendency of the ACI image may be individually predicted from each of the individual features $F_1$ to $F_k$. The tendency of the ACI image may be predicted using a combination of the shared features $F_{k+1}$ to $F_n$. The tendency of the ACI image may be tendency of a line width of the ACI image.

The semiconductor process machine learning module 200 may segment each of the first to k-th features $F_1$ to $F_k$ classified as the individual features into sub-features corresponding to the first to third regions R1, R2, and R3. Each of the first to k-th features $F_1$ to $F_k$ may be segmented into first to third sub-features $F_1^1$ to $F_1^3$, $F_2^1$ to $F_2^3$, …, $F_k^1$ to $F_k^3$ corresponding to the first to third regions R1, R2, and R3. For example, the first feature $F_1$ may include the first sub-feature $F_1^1$ corresponding to the first region R1, the second sub-feature $F_1^2$ corresponding to the second region R2, and the third sub-feature $F_1^3$ corresponding to the third region R3. The k-th feature $F_k$ may include the first sub-feature $F_k^1$ corresponding to the first region R1, the second sub-feature $F_k^2$ corresponding to the second region R2, and the third sub-feature $F_k^3$ corresponding to the third region R3.

For example, it may be assumed that the first layout L1 includes the first to fourth areas R1, R2, R3, the first feature $F_1$ and the second feature $F_2$ are extracted, the first feature $F_1$ is a size of the patterns in the first layout L1, the second feature $F_2$ is a density of the patterns in the first layout L1, the first feature $F_1$ is classified as the individual feature and the second feature $F_2$ is classified as the shared feature. The first feature $F_1$ includes a first sub-features $F_1^1$ that is a size of the first pattern P1 in the first region R1, a second sub-features $F_1^2$ that is a size of the second pattern P2 in the second region R2, a third sub-features $F_1^3$ that is a size of the third pattern P3 in the third region R3, and a fourth sub-features $F_1^4$ that is a size of the fourth pattern P4 in the fourth region R4. The second feature $F_2$ is a density of the first to fourth patterns P1, P2, P3 and P4 included in the first layout L1. That is, the second feature $F_2$ is the total area of the first to fourth patterns P1 , P2 , P3 , and P4 relative to the total area of the first to fourth regions R1 , R2 , R3 , and R4 .

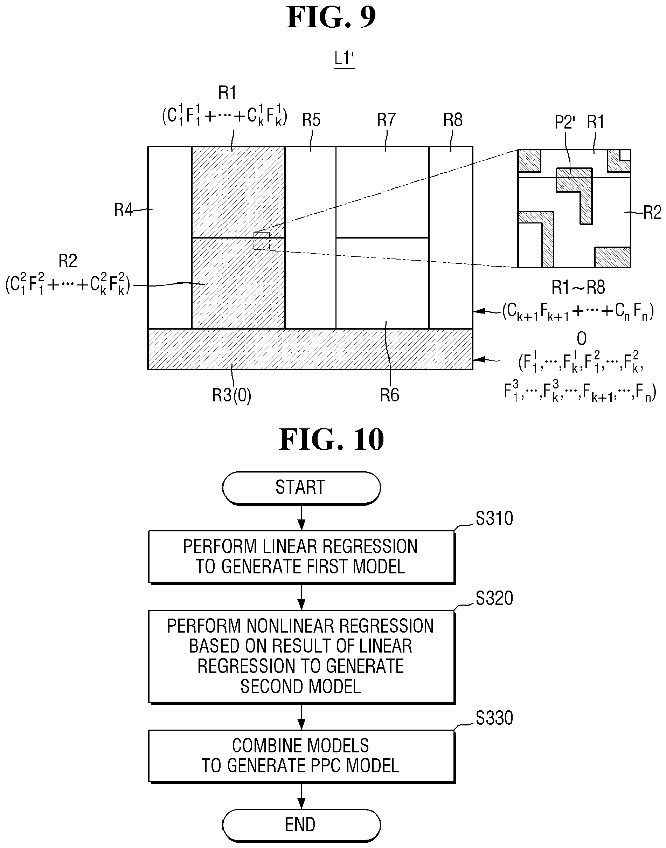

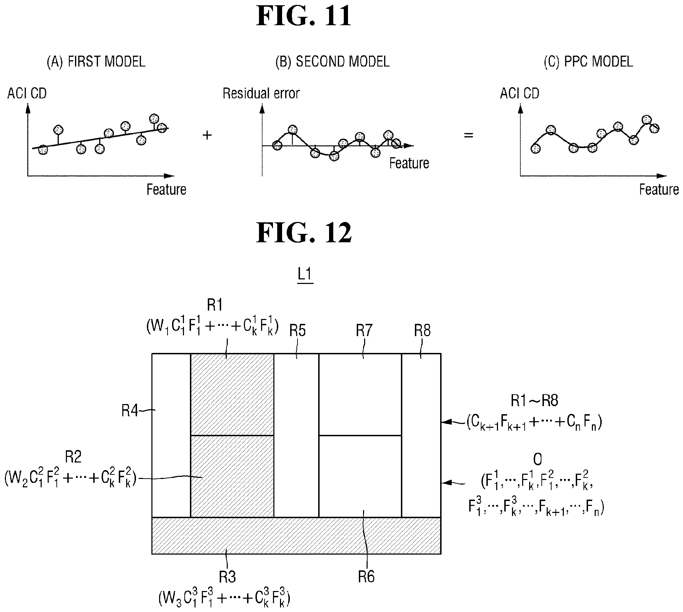

The semiconductor process machine learning module 200 may generate the process proximity effect correction model based on the first to k-th features $F_1$ to $F_k$, each including the first to third sub-features $F_1^1$ to $F_1^3$, $F_2^1$ to $F_2^3$, ..., $F_k^1$ to $F_k^3$ , and the (k+1)-th to n-th features $F_{k+1}$ to $F_n$. The semiconductor process machine learning module 200 may perform machine learning on feature data corresponding to the first to k-th features $F_1$ to $F_k$, each including the first to third sub-features $F_1^1$ to $F_1^3$, $F_2^1$ to $F_2^3$, ..., $F_k^1$ to $F_k^3$ , and the (k+1)-th to n-th features $F_{k+1}$ to $F_n$ and the ACI measure data and thus may generate a process proximity effect correction model. In an embodiment, the process proximity effect correction model is generated by combining a first model generated by performing first machine learning based on linear regression with a second model generated by performing second machine learning based on non-linear regression. The first model may be expressed by $(C_1^1 F_1^1 + \cdots + C_k^1 F_k^1) + (C_1^2 F_1^2 + \cdots + C_k^2 F_k^2)$ + $(C_1^3 F_1^3 + \cdots + C_k^3 F_k^3)$ + $(C_{k+1} F_{k+1} + \cdots + C_n F_n)$ + $\mathcal{O}(F_1^1, \cdots, F_k^1, F_1^2, \cdots, F_k^2, F_1^3, \cdots, F_k^3, \cdots, F_{k+1}, \cdots, F_n)$ . The second model may be expressed by $\mathcal{O}(F_1^1, \cdots, F_k^1, F_1^2, \cdots, F_k^2, F_1^3, \cdots, F_k^3, \cdots, F_{k+1}, \cdots, F_n)$ . The second model $\mathcal{O}$ may be a function with a first or higher order term on each of the features $F_1^1, \cdots, F_k^1, F_1^2, \cdots, F_k^2, F_1^3, \cdots, F_k^3, \cdots, F_{k+1}, \cdots, F_n$ . The first model and the second model will be described in detail later with reference to FIGS. 10 and 11. Each of $C_1^1, \ldots, C_k^1, C_1^2, \ldots, C_k^2, C_1^3, \ldots, C_k^3$ , and $C_{k+1}, \ldots, C_n$ are coefficient of each of features $F_1^1, \cdots, F_k^1, F_1^2, \cdots, F_k^2, F_1^3, \cdots, F_k^3, \cdots, F_{k+1}, \cdots, F_n$ .

For example, the process proximity effect correction model may learn ACI measure data from the first pattern included in the first region R1 by inputting feature data corresponding to respective first sub-features $F_1^1$ to $F_k^1$ of the first to k-th features $F_1$ to $F_k$ to the respective first sub-features $F_1^1$ to $F_k^1$ of the first to k-th features $F_1$ to $F_k$, inputting feature data corresponding to respective (k+1)-th to n-th features $F_{k+1}$ to $F_n$ to the (k+1)-th to n-th features $F_{k+1}$ to $F_n$, and inputting 0 as respective second and third sub-features $F_1^2$ to $F_1^3$, ..., $F_k^2$ to $F_k^3$ of the first to k-th features $F_1$ to $F_k$.

The process proximity effect correction model may learn ACI measure data for the fifth pattern included in the fifth region R5 by inputting 0 as first to third sub-features $F_1^1$ to $F_1^3$ , $F_2^1$ to $F_2^3$, ..., $F_k^1$ to $F_k^3$ of each of the first to k-th features $F_1$ to $F_k$ and inputting feature data corresponding to respective (k+1)-th to n-th features $F_{k+1}$ to $F_n$ as the respective (k+1)-th to n-th features $F_{k+1}$ to $F_n$.

The process proximity effect correction model may learn ACI measure data for the first pattern included in the first region R1 and in contact with a boundary line between the first region R1 and a region neighboring to the first region R1. For example, the process proximity effect correction model may learn ACI measure data for the first pattern included in the first region R1 and in contact with a boundary line between the first region R1 and the second region R2 neighboring to the first region R1 by inputting feature data corresponding to respective first sub-features $F_1^1$ to $F_k^1$ of the first to k-th features $F_1$ to $F_k$ as the respective first sub-features $F_1^1$ to $F_k^1$ of the first to k-th features $F_1$ to $F_k$, inputting feature data corresponding to respective second sub-features $F_1^2$ to $F_k^2$ of the first to k-th features $F_1$ to $F_k$ as the respective second sub-features $F_1^2$ to $F_k^2$ of the first to k-th features $F_1$ to $F_k$, inputting feature data corresponding to respective (k+1)-th to n-th features $F_{k+1}$ to $F_n$ to the (k+1)-th to n-th features $F_{k+1}$ to $F_n$, and inputting 0 as respective third sub-features $F_1^3$ to $F_k^3$ of the first to k-th features $F_1$ to $F_k$.

In the process proximity effect correction method according to an embodiment, the process proximity effect correction model may be generated by inputting feature data corresponding to only a sub-feature of a corresponding region on which learning is performed among the sub-features as the only sub-feature, and inputting 0 as the remaining sub-features among the sub-features. Therefore, even when one feature is segmented into a plurality of sub-features corresponding to the regions, an amount of computation for training the process proximity effect correction model does not increase linearly based on the number of the plurality of sub-features.

Referring back to FIGS. 1 and 2, the semiconductor process machine learning module 200 may correct the first layout in S170. The semiconductor process machine learning module 200 may correct the first layout using the process proximity effect correction model. In one example, the process proximity effect correction model may correct the features of the plurality of patterns to correct the first layout. The process proximity effect correction model may correct the features of the plurality of patterns, such as, for example, sizes of the plurality of patterns, shapes of the plurality of patterns, and the like. Accordingly, features of other patterns may also be corrected.

The semiconductor process machine learning module 200 may perform machine learning-based inference on the first layout corrected using the process proximity effect correction model to generate a predicted ACI image in S180.

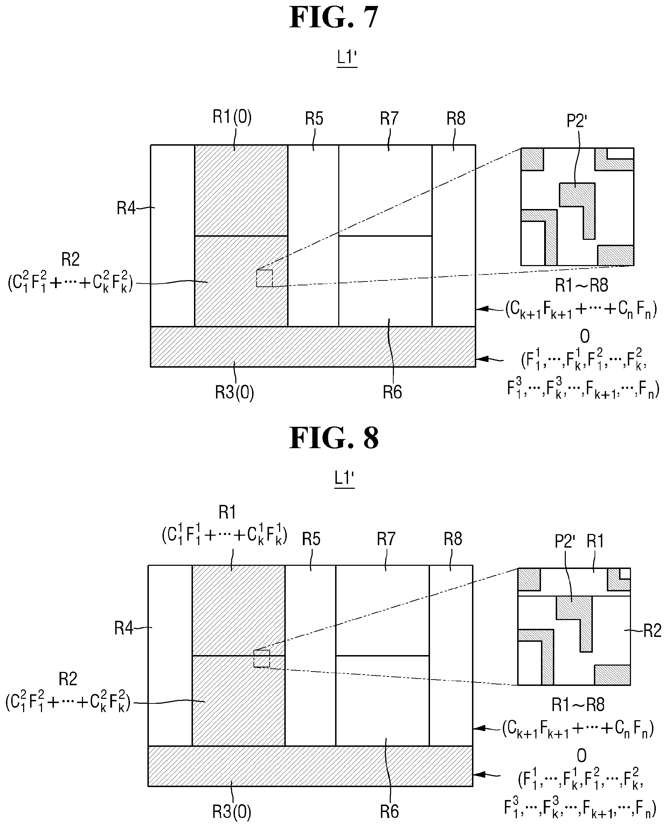

Referring to FIG. 7, the process proximity effect correction model may correct a second pattern P2' of the second region R2 to generate a corrected first layout L1'. The process proximity effect correction model may identify that a pattern being corrected is the second pattern P2' included in the second region R2, using a marker ([Marker2] of FIG. 4) indicating the second region R2 or the sub-layout ([Sublayout 2] of FIG. 5) indicating the second region R2. Thus, the process proximity effect correction model may perform machine learning-based inference on the corrected first layout L1' using the second sub-features $F_1^2$ to $F_k^2$ corresponding to the second region R2 and the (k+1)-th to n-th features $F_{k+1}$ to $F_n$ corresponding to the first to eighth regions R1 to R8.

Specifically, the process proximity effect correction model may input features data corresponding to respective second sub-features $F_1^2$ to $F_k^2$ of the first to k-th features $F_1$ to $F_k$ as the respective second sub-features $F_1^2$ to $F_k^2$ of the first to k-th features $F_1$ to $F_k$, input features data corresponding to the (k+1)-th to n-th features $F_{k+1}$ to $F_n$ as the (k+1)-th to n-th features $F_{k+1}$ to $F_n$, input 0 to the respective first sub-features $F_1^1$ to $F_k^1$ of the first to k-th features $F_1$ to $F_k$, and input 0 as respective third sub-features $F_1^3$ to $F_k^3$ of the first to k-th features $F_1$ to $F_k$. Accordingly, the process proximity effect correction model may perform machine learning-based inference on the corrected first layout L1' to generate a predicted ACI image.

Referring to FIG. 8, the process proximity effect correction model may correct the second pattern P2' of the second region R2 to generate the corrected first layout L1'. The second pattern P2' may contact a boundary line between the first region R1 and a neighboring region thereto. In one example, the second pattern P2' may may contact the boundary line between the first region R1 and the second region R2. The process proximity effect correction model may identify that the pattern being corrected is the second pattern P2' included in the second region R2 and in contact with the boundary line between the first region R1 and the second region R2, using a marker ([Marker2] of FIG. 4) indicating the second region R2 and a marker indicating the first region R1, or a sub-layout ([Sublayout 2] of FIG. 5) indicating the second region R2 and a sub-layout indicating the first region R1. Thus, the process proximity effect correction model may perform machine learning-based inference on the corrected first layout L1' using the first sub-features $F_1^1$ to $F_k^1$

corresponding to the first region R1, the second sub-features $F_1^2$ to $F_k^2$ corresponding to the second region R2 and the (k+1)-th to n-th features $F_{k+1}$ to $F_n$ corresponding to the first to eighth regions R1 to R8.

Specifically, the process proximity effect correction model may input features data corresponding to respective first sub-features $F_1^1$ to $F_k^1$ of the first to k-th features $F_1$ to $F_k$ to the respective first sub-features $F_1^1$ to $F_k^1$ of the first to k-th features $F_1$ to $F_k$, input features data corresponding to respective second sub-features $F_1^2$ to $F_k^2$ of the first to k-th features $F_1$ to $F_k$ to the respective second sub-features $F_1^2$ to $F_k^2$ of the first to k-th features $F_1$ to $F_k$, input features data corresponding to the (k+1)-th to n-th features $F_{k+1}$ to $F_n$ to the (k+1)-th to n-th features $F_{k+1}$ to $F_n$, and input 0 as respective third sub-features $F_1^3$ to $F_k^3$ of the first to k-th features $F_1$ to $F_k$. Accordingly, the process proximity effect correction model may perform machine learning-based inference on the corrected first layout L1' to generate a predicted ACI image.

The process proximity correction model according to an embodiment performs an inference on two regions defining the boundary line therebetween for a pattern contacting the boundary line. Accordingly, consistency of the inference of the ACI image on the pattern contacting the boundary line may be increased.

Referring to FIG. 9, the process proximity effect correction model may correct the second pattern P2' of the second region R2 to generate a corrected first layout L1'. The second pattern P2' may be disposed on the second region R2 and a region adjacent to the second region R2. For example, the second pattern P2' may be disposed on the second region R2 and the first region R1. That is, a portion of the second pattern P2' may be disposed in the first region R1, and the remainder of the second pattern P2' may be disposed in the second region R2. The process proximity effect correction model may identify that a pattern being corrected is the second pattern P2' disposed on the second region R2 and the first region R1, using a marker ([Marker2] in FIG. 4) indicating the second region R2, and a marker indicating the first region R1, or a sub-layout ([Sublayout 2] in FIG. 5) indicating the second region R2 and a sub-layout representing the first region R1. Thus, the process proximity effect correction model may perform machine learning-based inference on the corrected first layout L1' using the first sub-features $F_1^1$ to $F_k^1$ corresponding to the first region R1, the second sub-features $F_1^2$ to $F_k^2$ corresponding to the second region R2 and the (k+1)-th to n-th features $F_{k+1}$ to $F_n$ corresponding to the first to eighth regions R1 to R8, as described above with reference to FIG. 6.

The process proximity correction model according to an embodiment performs an inference on two regions defining the boundary line therebetween for a pattern disposed on the boundary line. Accordingly, consistency of the inference of the ACI image on the pattern disposed on the boundary line may be increased.

Referring back to FIG. 1 and FIG. 2, the semiconductor process machine learning module 200 may determine whether the predicted ACI image is acceptable in S190. For example, when a difference between the predicted ACI image and the target ACI image is greater than a set value, the semiconductor process machine learning module 200 may determine that the predicted ACI image is not acceptable. For example, the difference may be measured based on, for example, a root-mean-squared calculation; however, example embodiments are not limited thereto.

The semiconductor process machine learning module 200 may return to S170 when the predicted ACI image is not acceptable (S190=N). The semiconductor process machine learning module 200 may re-correct the corrected first layout. The semiconductor process machine learning module 200 may repeat S170 to S190 until the difference between the predicted ACI image and the target ACI image is smaller than or equal to the set value.

When the predicted ACI image is acceptable (S190=Y), the semiconductor process machine learning module 200 may generate a second layout in S195. The semiconductor process machine learning module 200 may generate the first layout corrected in S170 as the second layout. Accordingly, the second layout may be generated by performing the process proximity correction on the first layout. For example, the semiconductor process machine learning module 200 may correct the first layout to generate the second layout.

The process proximity correction method according to an embodiment performs process proximity correction on several regions using one process proximity correction model. Therefore, in this scheme, a Turn Around Time (TAT) may be reduced, compared to a scheme in which a process proximity correction model is generated on each region.

FIG. 10 is an illustrative flowchart illustrating a method for generating a process proximity correction model according to an embodiment. FIG. 11 is an illustrative view showing a method for generating a process proximity correction model according to an embodiment.

Referring to FIG. 1 and FIG. 10, the semiconductor process machine learning module 200 performs linear regression in S310. The semiconductor process machine learning module 200 may generate a first model by performing first machine learning based on linear regression on a plurality of features and ACI measure data.

The semiconductor process machine learning module 200 performs non-linear regression based on a result of the linear regression to generate a second model in S320. The semiconductor process machine learning module 200 generate the second model by performing second machine learning based on a non-linear regression on a result of the first model.

The semiconductor process machine learning module 200 may add the first model and the second model to each other to generate a process proximity correction model in S330.

Alternatively, the semiconductor process machine learning module 200 may generate a process proximity correction model by adding an additional model generated by performing machine learning based on at least one of various algorithms to the first model and the second model.

Referring to FIG. 11, a first model 'A' may learn an overall tendency of an ACI line width from features. Accordingly, a coefficient for the feature may be determined. A second model 'B' may learn a residual error of the ACI line width from the features generated in the first model 'A'. A process proximity correction model 'C' may be generated by adding the first model 'A' and the second model 'B' to each other. Accordingly, the process proximity correction model according to an embodiment may infer the ACI line width with more stability and accuracy. The semiconductor process machine learning module 200 may combine the first model and the second model with each other to generate a process proximity correction model C in S330.

For example, it may be assumed that the feature is a size of the patterns. The first model 'A' learns an overall tendency of the ACI line width according to the size of the patterns. The first model 'A' learns an overall relationship of the ACI line width according to the size of the patterns.

For example, referring to FIG. 6, a first machine learning based on linear regression may be performed on ACI line widths of respective first sub-features $F_1^1$ to $F_k^1$ of the first to k-th features $F_1$ to $F_k$, respective second sub-features $F_1^2$ to $F_k^2$ of the first to k-th features $F_1$ to $F_k$, respective third sub-features $F_1^3$ to $F_k^3$ of the first to k-th features $F_1$ to $F_k$, and the (k+1)-th to n-th features $F_{k+1}$ to $F_n$. Thus, a first model expressed by $(C_1^1 F_1^1 + \cdots + C_k^1 F_k^1) + (C_1^2 F_1^2 + \cdots + C_k^2 F_k^2) + (C_1^3 F_1^3 + \cdots + C_k^3 F_k^3) + (C_{k+1} F_{k+1} + \cdots + C_n F_n)$ may be generated.

Then, a second machine learning based on non-linear regression may be performed on residual errors generated in the first model on the respective first sub-features $F_1^1$ to $F_k^1$ of the first to k-th features $F_1$ to $F_k$, the respective second sub-features $F_1^2$ to $F_k^2$ of the first to k-th features $F_1$ to $F_k$, the respective third sub-features $F_1^3$ to $F_k^3$ of the first to k-th features $F_1$ to $F_k$, and the (k+1)-th to n-th features $F_{k+1}$ to $F_n$. Thus, a second model expressed by $\mathcal{O}(F_1^1, \cdots, F_k^1, F_1^2, \cdots, F_k^2, F_1^3, \cdots, F_k^3, \cdots, F_{k+1}, \cdots, F_n)$ may be generated. $\mathcal{O}$ may be a function having a first or higher order term on each of the features $F_1^1, \cdots, F_k^1, F_1^2, \cdots, F_k^2, F_1^3, \cdots, F_k^3, \cdots, F_{k+1}, \cdots, F_n$.

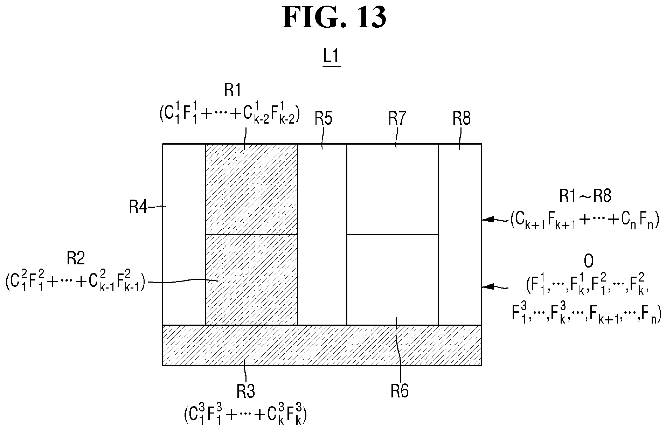

FIG. 12 and FIG. 13 are illustrative diagrams illustrating a process proximity effect correction method according to an embodiment. Differences thereof from those as described above with reference to FIGS. 1 to 11 will be mainly described.

Referring to FIG. 1 and FIG. 12, the semiconductor process machine learning module 200 may apply a weight to at least one of the first to k-th features $F_1$ to $F_k$, each including the first to third sub-features $F_1^1$ to $F_1^3$, $F_2^1$ to $F_2^3$, ..., $F_k^1$ to $F_k^3$, and the (k+1)-th to n-th features $F_{k+1}$ to $F_n$. The semiconductor process machine learning module 200 may apply a weight to a specific region of the first to eighth regions R1 to R8 to control consistency of inference of ACI line width of the specific region. Accordingly, a process proximity effect correction model with different consistency of inference of the ACI line width of the specific region from those of the other regions may be generated. For example, a weight may be multiplied by each sub-feature associated with a region to generate several products, and the products may be summed together generate a value for the region.

For example, the semiconductor process machine learning module 200 may apply a first weight $W_1$ to the first sub-feature $F_1^1$ of the first feature $F_1$, apply a second weight $W_2$ to the second sub-feature $F_1^2$ of the first features $F_1$, and apply a third weight $W_3$ to a third sub-feature $F_1^3$ of the first feature $F_1$. Thus, consistencies of inferences of the ACI line widths of the first to third sub-features $F_1^1, F_1^2,$ and $F_1^3$ may be different from each other. Alternatively, the semiconductor process machine learning module 200 may apply different weights to respective first sub-features $F_1^1$ to $F_k^1$ of the first to k-th features $F_1$ to $F_k$, respective second sub-features $F_1^2$ to $F_k^2$ of the first to k-th features $F_1$ to $F_k$, and respective third sub-features $F_1^3$ to $F_k^3$ of the first to k-th features $F_1$ to $F_k$, respectively.

Referring to FIG. 1 and FIG. 13, the semiconductor process machine learning module 200 may allow the numbers of sub-features of the regions to be different from each other. The semiconductor process machine learning module 200 may segment each of two different features in a different manner such that the numbers of sub-features of the regions are different from each other.

For example, the semiconductor process machine learning module 200 may segment each of first to (k-2)-th features into sub-features corresponding to the first to third regions R1, R2, and R3. Thus, each of the first to (k-2)-th features may include first to third sub-features $F_1^1$ to $F_1^3$, $F_2^1$ to $F_2^3$, ..., $F_{k-2}^1$ to $F_{k-2}^3$. The semiconductor process machine learning module 200 may segment a (k-1)-th feature into sub-features corresponding to the second and third regions R2 and R3. Thus, the (k-1)-th feature may include second and third sub-features $F_{k-1}^2, F_{k-1}^3$. The semiconductor process machine learning module 200 may allocate a k-th feature $F_k^3$ only to the third region R3. The numbers of the sub-features assigned to the first to third regions R1, R2, and R3 may be different from each other. Accordingly, a process proximity effect correction model with different consistency of inference of the ACI line width of a specific region from those of the other regions may be generated.

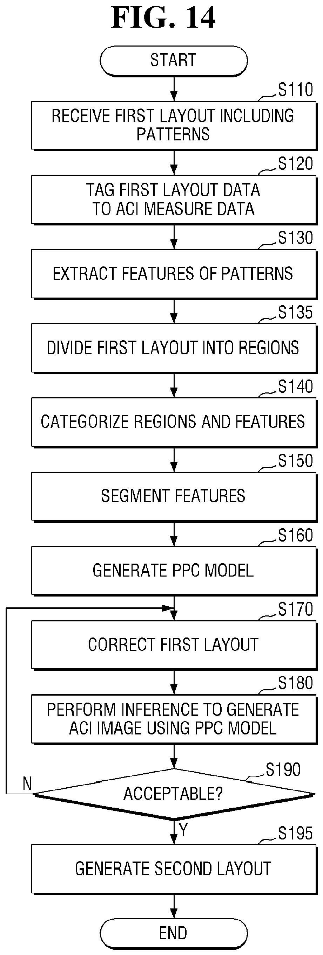

FIG. 14 is an illustrative flowchart illustrating a process proximity correction method according to an embodiment. Differences thereof from those as described above with reference to FIGS. 1 to 11 will be mainly described.

Referring to FIG. 1 and FIG. 14, after S130, the semiconductor process machine learning module 200 may divide the first layout into a plurality of regions in S135. For example, the semiconductor process machine learning module 200 may divide the first layout into a plurality of regions based on a value input through one of the plurality of user interfaces 160.

Subsequently, the semiconductor process machine learning module 200 may perform S140 to S195. For example, the categorize of regions and features of step S140 may be performed with respect to the regions resulting from the dividing of the first layout.

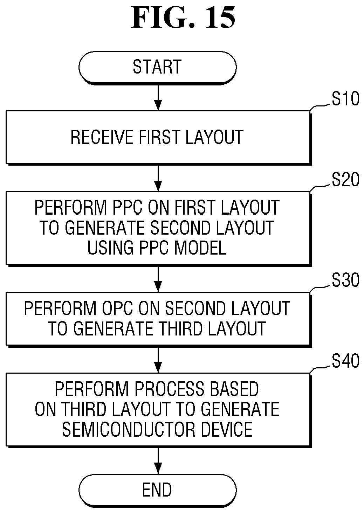

FIG. 15 is an illustrative flowchart illustrating a method for manufacturing a semiconductor device according to an embodiment.

Referring to FIG. 1 and FIG. 15, the semiconductor process machine learning module 200 receives a first layout in S10. For example, the first layout may be a target layout desired to be obtained upon after-cleaning inspection (ACI).

The semiconductor process machine learning module 200 generates a second layout by performing process proximity correction on the first layout in S20. The process proximity correction may be carried out by performing machine learning-based inference on the features of the patterns of the first layout. The process proximity correction may be performed using the process proximity correction model as described above using FIG. 1 to FIG. 14. The second layout may be a target layout of a photoresist that is desired to be obtained at After Development Inspection (ADI).

The process proximity correction may compensate for a change in a shape of the semiconductor pattern caused due to an influence of characteristics of the patterns and influence of an etch skew when etching is performed. For example, in the process proximity correction, a shape of a portion expected to be deformed in a specific pattern is pre-modified and this pre-modification is reflected in the layout. Thus, the change in the shape during the etching may be pre-compensated for.

The semiconductor process machine learning module 200 generates a third layout by performing optical proximity correction (OPC) on the second layout in S30. The third layout may be a layout of a photomask.

The optical proximity correction may compensate for a change in a shape of a photoresist pattern caused due to influence of the characteristics of patterns to be converted to the photoresist pattern and influence of a skew. For example, the optical proximity correction may pre-modify a shape of a portion expected to be deformed in a specific pattern and this pre-modification may be reflected in the layout, thereby pre-compensating for the change in the shape during etching.

A semiconductor device may be manufactured based on the third layout in S40. For example, photoresist patterns may be formed on a target (for example, a semiconductor process target to be manufactured into a semiconductor device) using a photomask of the third layout. Exposed portions of the target that are not covered with the photoresist patterns may be removed in an etching process. Thereafter, the photoresist may be removed. Thus, the etching process is terminated.

Although embodiments of the present disclosure have been described with reference to the accompanying drawings, the present disclosure is not limited to the disclosed embodiments, but may be implemented in various different forms as will be understood by those skilled in the art. Therefore, the embodiments are examples only and not to be construed as a limitation.

**Claims**

1.  A process proximity correction method comprising:

    receiving a first layout including first to m-th regions, wherein the first to m-th regions include respective first to m-th patterns, where m is a natural number equal to or greater than 3;
    extracting a total of first to n-th features from the first to m-th patterns in the first layout; and
    generating a second layout by performing machine learning-based process proximity correction on the first layout based on the first to n-th features of the first to m-th patterns, where n is a natural number greater than or equal to 2,
    wherein each of first to k-th features includes first to l-th sub-features of each of the first to l-th patterns included in each of the first to l-th regions, where k is a natural number smaller than or equal to n and l is a natural number smaller than or equal to m.

2.  The method of claim 1, wherein the generating of the second layout includes:
    ; and
    generating an after-cleaning inspection, ACI, image by performing machine learning-based inference based on the first to n-th features.

3.  The method of claim 2, wherein the generating of the ACI image includes:

    performing first machine learning-based inference on the first to n-th features, wherein the first machine learning-based inference is based on linear regression; and
    performing second machine learning-based inference on a result of the first machine learning-based inference, wherein the second machine learning-based inference is based on non-linear regression.

4.  The method of claim 3, wherein the performing of the first machine learning-based inference includes performing the first machine learning-based inference on each of first to l-th sub-features included in each of the first to k-th features.

5.  The method of claim 2, 3 or 4, wherein the method further comprises:

    correcting the first layout based on a difference between the ACI image and a target ACI image; and
    performing the machine learning-based inference based on the first to n-th features of the corrected first layout for generating a corrected ACI image.

6.  The method of claim 5, wherein the correcting of the first layout includes correcting the first pattern of the first region, wherein generating the corrected ACI image includes:
    generating the corrected ACI image by performing the machine learning-based inference based on the (k+1)-th to n-th features of the corrected first pattern, and a first sub-feature of each of the first to k-th features of the corrected first pattern.

7.  The method of claim 5 or 6, wherein the correcting of the first layout includes correcting a pattern of one the first to m-th regions,
    wherein the generating the corrected ACI image includes:

generating the corrected ACI image by performing the machine learning-based inference based on the (k+1)-th to n-th features of the corrected pattern.

8. The method of any one of claims 1 to 7, wherein a first sub-feature of each of the first to k-th features, of the first pattern included in the first region has a first weight,
wherein the first sub-feature of each of the first to k-th features, of the second pattern included in the second region has a second weight different from the first weight.

9. A process proximity correction method as claimed in any one preceding claim comprising:

   receiving the first layout including a first region including a first pattern, a second region including a second pattern, and a third region including a third pattern;
   extracting first to third features of the first to third patterns; and
   generating a process proximity correction model, wherein the generating of the process proximity correction model includes performing machine learning on:

      first-first feature data about the first feature of the first pattern included in the first region;
      first-second feature data about the first feature of the second pattern included in the second region;
      second feature data about the second feature of the first to third patterns respectively included in the first to third regions; and
      measure data of an after-cleaning inspection (ACI) image generated from the first layout;

   correcting the first layout using the generated process proximity correction model to generate the second layout;
   predicting an ACI image of the second layout using the process proximity correction model; and
   correcting the second layout based on a difference between the predicted ACI image and a target ACI image.

10. The method of claim 9, wherein each of the first to third patterns includes a plurality of sub-patterns.

11. The method of claim 9 or 10, wherein the first feature includes a plurality of first sub-features,

   wherein the first-first feature data includes a plurality of first-first sub-feature data about the plurality of first sub-features of the first pattern included in the first region,
   wherein the first-second feature data includes a plurality of second-first sub-feature data about the plurality of first sub-features of the second pattern included in the second region.

12. The method of claim 9, 10 or 11, wherein the second feature includes a plurality of second sub-features,
wherein the second feature data includes a plurality of second sub-feature data about the plurality of second sub-features of the first to third patterns.

13. The method of any one of claims 9 to 12, wherein the generating of the process proximity correction model includes:

   performing first machine learning on the first-first feature data, the first-second feature data, and the second feature data to generate a first model, wherein the first machine learning is based on linear regression; and
   performing second machine learning on a result of the first model to generate a second model, wherein the second machine learning is based on non-linear regression.

14. The method of any one of claims 9 to 13, wherein the generating of the process proximity correction model includes:

   performing machine learning on the measure data of the ACI image, and the first-first feature data except for the first-second feature data and the second feature data;
   performing machine learning on the measure data of the ACI image, and the first-second feature data except for the first-first feature data and the second feature data; and,
   performing machine learning on the measure data of the ACI image, and the second feature data except for the first-first feature data and the first-second feature data.

15. The method of any one of claims 9 to 14, wherein the first pattern overlaps a boundary line between the first region and the second region contacting each other,
wherein the generating of the process proximity correction model includes performing machine learning on the measure data of the ACI image, and the first-first feature data and the first-second feature data except for the second feature data.

# FIG. 1

100

Computing Device  110

Processors

111 — CPU
112 — AP
113 — NPU
114 — NP
115 — GPU
• • •

200

Semiconductor
Process Machine
Learning Module

120 — Random Access Memory
130 — Device Driver
140 — Storage Device
150 — Modem

160

User Interfaces

161 — Display
162 — Speaker
163 — Mouse
164 — Keyboard
165 — Touch Input Device
• • •

# FIG. 2

START

S110
RECEIVE FIRST LAYOUT INCLUDING PATTERNS

S120
TAG FIRST LAYOUT DATA TO ACI MEASURE DATA

S130
EXTRACT FEATURES OF PATTERNS

S140
CATEGORIZE REGIONS AND FEATURES

S150
SEGMENT FEATURES

S160
GENERATE PPC MODEL

S170
CORRECT FIRST LAYOUT

S180
PERFORM INFERENCE TO GENERATE ACI IMAGE USING PPC MODEL

S190
ACCEPTABLE?    N

Y

S195
GENERATE SECOND LAYOUT

END

# FIG. 3

L1

R1(P1)  R5(P5)  R7(P7)  R8(P8)  P2

R4(P4)

R2(P2)

→ (F₁~Fₖ)

R3(P3)  R6(P6)

DR2
→DR1

# FIG. 4

L1

R1  R5  R7  R8

R4

R2
([Marker2] x: [A, B] y: [C, D])

R3  R6

# FIG. 5

<u>L1</u>

R1    R5    R7    R8

R4

R2
([Sublayout 2]: GDS2)

R3    R6

# FIG. 6

<u>L1</u>

R1
$(C_1^1 F_1^1 + \cdots + C_k^1 F_k^1)$    R5    R7    R8

R4

R1~R8
$(C_{k+1} F_{k+1} + \cdots + C_n F_n)$

R2
$(C_1^2 F_1^2 + \cdots + C_k^2 F_k^2)$

0
$(F_1^1, \cdots, F_k^1, F_1^2, \cdots, F_k^2,$
$F_1^3, \cdots, F_k^3, \cdots, F_{k+1}, \cdots, F_n)$

R3
$(C_1^3 F_1^3 + \cdots + C_k^3 F_k^3)$    R6

# FIG. 7

L1'

R1(0)  R5  R7  R8

P2'

R4

R2
$(C_1^2 F_1^2 + \cdots + C_k^2 F_k^2)$

R3(0)  R6

R1~R8
$(C_{k+1} F_{k+1} + \cdots + C_n F_n)$

O
$(F_1^1, \cdots, F_k^1, F_1^2, \cdots, F_k^2,$
$F_1^3, \cdots, F_k^3, \cdots, F_{k+1}, \cdots, F_n)$

# FIG. 8

L1'

R1
$(C_1^1 F_1^1 + \cdots + C_k^1 F_k^1)$  R5  R7  R8

P2'  R1

R4

R2
$(C_1^2 F_1^2 + \cdots + C_k^2 F_k^2)$

R2

R3(0)  R6

R1~R8
$(C_{k+1} F_{k+1} + \cdots + C_n F_n)$

O
$(F_1^1, \cdots, F_k^1, F_1^2, \cdots, F_k^2,$
$F_1^3, \cdots, F_k^3, \cdots, F_{k+1}, \cdots, F_n)$

# FIG. 9

L1'

R1
$(C_1^1 F_1^1 + \cdots + C_k^1 F_k^1)$   R5   R7   R8

P2'  R1

R4

R2
$(C_1^2 F_1^2 + \cdots + C_k^2 F_k^2)$

R2

R1~R8
$(C_{k+1} F_{k+1} + \cdots + C_n F_n)$

0
$(F_1^1, \cdots, F_k^1, F_1^2, \cdots, F_k^2,$
$F_1^3, \cdots, F_k^3, \cdots, F_{k+1}, \cdots, F_n)$

R3(0)   R6

# FIG. 10

START

PERFORM LINEAR REGRESSION
TO GENERATE FIRST MODEL ⟶ S310

PERFORM NONLINEAR REGRESSION
BASED ON RESULT OF LINEAR
REGRESSION TO GENERATE
SECOND MODEL ⟶ S320

COMBINE MODELS
TO GENERATE PPC MODEL ⟶ S330

END

# FIG. 11

(A) FIRST MODEL

ACI CD

Feature

+

(B) SECOND MODEL

Residual error

Feature

=

(C) PPC MODEL

ACI CD

Feature

# FIG. 12

<u>L1</u>

R1
$(W_1 C_1^1 F_1^1 + \cdots + C_k^1 F_k^1)$  R5      R7      R8

R4

R2
$(W_2 C_1^2 F_1^2 + \cdots + C_k^2 F_k^2)$

R1~R8
$(C_{k+1} F_{k+1} + \cdots + C_n F_n)$

O
$(F_1^1, \cdots, F_k^1, F_1^2, \cdots, F_k^2,$
$F_1^3, \cdots, F_k^3, \cdots, F_{k+1}, \cdots, F_n)$

R3
$(W_3 C_1^3 F_1^3 + \cdots + C_k^3 F_k^3)$

R6

# FIG. 13

L1

R1
$(C_1^1 F_1^1 + \cdots + C_{k-2}^1 F_{k-2}^1)$ R5 R7 R8

R4

R1~R8
$(C_{k+1} F_{k+1} + \cdots + C_n F_n)$

R2
$(C_1^2 F_1^2 + \cdots + C_{k-1}^2 F_{k-1}^2)$

O
$(F_1^1, \cdots, F_k^1, F_1^2, \cdots, F_k^2,$
$F_1^3, \cdots, F_k^3, \cdots, F_{k+1}, \cdots, F_n)$

R3
$(C_1^3 F_1^3 + \cdots + C_k^3 F_k^3)$

R6

# FIG. 14

START

S110

RECEIVE FIRST LAYOUT INCLUDING PATTERNS

S120

TAG FIRST LAYOUT DATA TO ACI MEASURE DATA

S130

EXTRACT FEATURES OF PATTERNS

S135

DIVIDE FIRST LAYOUT INTO REGIONS

S140

CATEGORIZE REGIONS AND FEATURES

S150

SEGMENT FEATURES

S160

GENERATE PPC MODEL

S170

CORRECT FIRST LAYOUT

S180

PERFORM INFERENCE TO GENERATE ACI IMAGE USING PPC MODEL

S190

ACCEPTABLE?    N

Y    S195

GENERATE SECOND LAYOUT

END

# FIG. 15

```
        ┌─────────────────┐
        │      START      │
        └─────────────────┘
                 │
                 ▼                              S10
    ┌──────────────────────────────┐
    │     RECEIVE FIRST LAYOUT      │
    └──────────────────────────────┘
                 │
                 ▼                              S20
    ┌──────────────────────────────┐
    │  PERFORM PPC ON FIRST LAYOUT  │
    │  TO GENERATE SECOND LAYOUT    │
    │       USING PPC MODEL         │
    └──────────────────────────────┘
                 │
                 ▼                              S30
    ┌──────────────────────────────┐
    │ PERFORM OPC ON SECOND LAYOUT  │
    │   TO GENERATE THIRD LAYOUT    │
    └──────────────────────────────┘
                 │
                 ▼                              S40
    ┌──────────────────────────────┐
    │     PERFORM PROCESS BASED     │
    │  ON THIRD LAYOUT TO GENERATE  │
    │    SEMICONDUCTOR DEVICE       │
    └──────────────────────────────┘
                 │
                 ▼
        ┌─────────────────┐
        │       END       │
        └─────────────────┘
```

Europäisches
Patentamt

European
Patent Office

Office européen
des brevets

## EUROPEAN SEARCH REPORT

Application Number

EP 23 16 5881

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2021/334444 A1 (LEE SOOYONG [KR] ET AL) 28 October 2021 (2021-10-28) * paragraphs [0050] - [0065], [0075] - [0094]; claims 1-20; figures 6, 11-15 * | 1-15 | INV. G03F1/36 G03F7/00 G06F30/398 |
| A | US 2022/035237 A1 (LEE SOO YONG [KR] ET AL) 3 February 2022 (2022-02-03) * paragraphs [0020] - [0027], [0076] - [0087]; figures 4a-5 * | 1-15 | |
| A | SEONGBO SHIM ET AL: "Machine learning (ML)-based lithography optimizations", 2016 IEEE ASIA PACIFIC CONFERENCE ON CIRCUITS AND SYSTEMS (APCCAS), 1 October 2016 (2016-10-01), pages 530-533, XP055686784, DOI: 10.1109/APCCAS.2016.7804021 ISBN: 978-1-5090-1570-2 * the whole document * | 1-15 | |

TECHNICAL FIELDS
SEARCHED (IPC)

G03F
G06F

The present search report has been drawn up for all claims

| Place of search | Date of completion of the search | Examiner |
|---|---|---|
| Munich | 4 August 2023 | Roesch, Guillaume |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 16 5881

This annex lists the patent family members relating to the patent documents cited in the above-mentioned European search report.
The members are as contained in the European Patent Office EDP file on
The European Patent Office is in no way liable for these particulars which are merely given for the purpose of information.

04-08-2023

| Patent document cited in search report | | Publication date | Patent family member(s) | | Publication date |
|---|---|---|---|---|---|
| US 2021334444 | A1 | 28-10-2021 | KR 20210133364 A | | 08-11-2021 |
| | | | US 2021334444 | A1 | 28-10-2021 |
| US 2022035237 | A1 | 03-02-2022 | KR 20220014541 A | | 07-02-2022 |
| | | | US 2022035237 | A1 | 03-02-2022 |

EPO FORM P0459

For more details about this annex : see Official Journal of the European Patent Office, No. 12/82